# EUROPEAN PATENT APPLICATION

(11) **EP 4 596 219 A1**
(43) Date of publication of application: **06.08.2025**
(21) Application number: 24218023.0
(22) Date of filing: 06.12.2024
(51) Int. Cl.: B29C 64/129, B29C 64/245, B29C 64/286, B33Y 10/00, B33Y 30/00, B33Y 80/00

(54) **AN APPARATUS FOR MAKING A STEREOLITHOGRAPHIC OBJECT, A METHOD FOR MAKING A STEREOLITHOGRAPHIC OBJECT, A MATERIAL, AND A STEREOLITHOGRAPHIC OBJECT**

(30) Priority: 08.12.2023 AU 2023903971
(71) Applicant: Zydex Pty Ltd, Alexandria, New South Wales 2015 (AU)
(72) Inventor: ELSEY, Justin, Alexandria, 2015 (AU)
(74) Representative: Bryers Intellectual Property Ltd

(57) **Abstract**

Disclosed herein is an apparatus (10) for making a stereolithographic object (106), a method for making a stereolithographic object, and a stereolithographic object. The apparatus comprises an actinic light emitter (18) having an actinic emission spectrum. The apparatus further comprises an actinic light spectrum modifier (20) having a spectral response profile and arranged to spectrally modify the actinic light (16), wherein the actinic emission spectrum and the spectral response profile cooperate to shorten an absorption depth of the actinic light in the photohardenable material (14) that is used for making the stereolithographic object.

## Description

### Technical field

The disclosure herein generally relates to an apparatus for making a stereolithographic object, a method for making a stereolithographic object, a material, and a stereolithographic object.

### Background

Additive fabrication - also known as *additive manufacturing* and *3D printing* - is a computer aided manufacturing technique, in which at least one material (the "material") is fused to fabricate an object. A machine that uses additive fabrication to fabricate an object is generally known as a three-dimensional printer ("3D printer"). There are many applications of additive manufacturing.

An additive fabrication process is stereolithography - also known as vat polymerisation. An object fabricated by stereolithography (a "stereolithographic object") - is fabricated layer by layer - and so comprises a fused plurality of solid layers. The first solid layer may be solidified on a build surface of the 3D printer. Each subsequent solid layer may be fabricated on a preceding solidified layer. Each solid layer is formed by polymerisation of a photohardenable liquid or resin. Polymerisation is initiated by exposing the photohardenable liquid to an actinic light. Photohardenable liquids may generally comprise at least one of polymerizable monomers and oligomers.

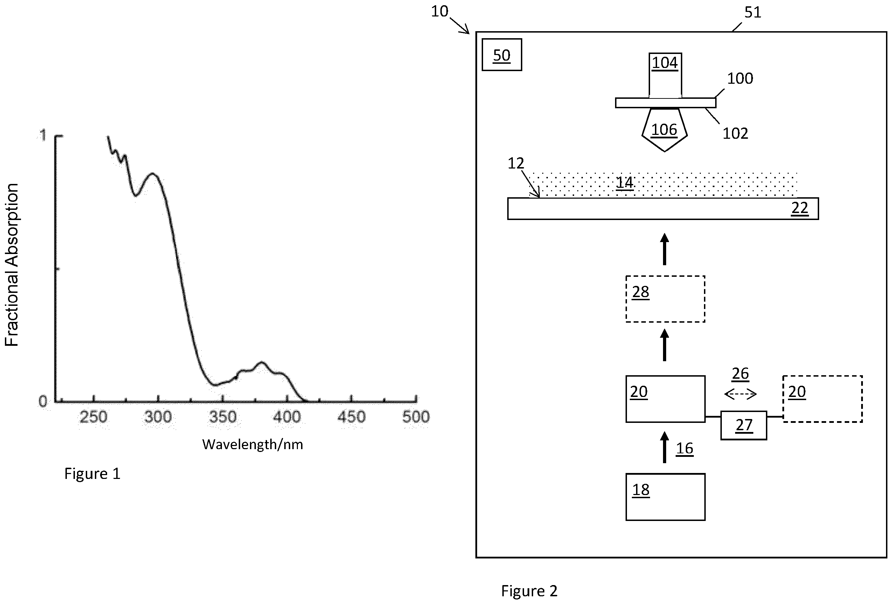

Photohardenable liquids may also generally comprise a photoinitiator that can initiate polymerization when exposed to actinic light. An example photoinitiator is 2,4,6-trimethylbenzoyldiphenyl phosphine oxide, sold commercially as LUCIRIN^{™} TPO^{™} ("TPO") by BASF, which is based on acyl-phosphine oxide. A light absorption spectrum for TPO is shown in figure 1. TPO exhibits a light absorption peak approximately extending between the wavelengths 350 nm and 410 nm, peaking at around 381 nm.

It may be feasible to use a light emitting diode to generate actinic light, for example an actinic light emitting diode ("aLED") with an emission spectrum peak at approximately 385 nm. Longer wavelength components of the actinic light - for example ~400 nm - may be less strongly absorbed by a photohardenable liquid containing TPO, for example, and so have a penetration depth into the photohardenable liquid greater than a desired solid layer thickness. This may be an issue when fabricating objects having an overhang or an internal cavity, in which case the weakly absorbed components of the actinic light can pass through the layer being formed and start hardening photohardenable liquid that should not be hardened. Consequently, fabricated objects may have (1) significantly reduced fidelity with respect to the object's specified configuration, and/or (2) reduced surface quality.

Generally, it may not be feasible to use shorter wavelength aLEDs to solve the problems of reduced fidelity and surface quality. This may be because, for example, optics suitable for shorter wavelengths are too expensive, otherwise inappropriate, or unavailable. Additionally, shorter wavelength aLEDs may not be available for the wavelengths required by the photoinitiators. Furthermore, shorter wavelength aLEDs typically have broad wavelength emission spectrums. For example, aLEDs having a nominally low peak emission wavelength of 365nm may still emit wavelengths above 400nm which may penetrate deeply into the photohardenable material and detrimentally affect the fidelity of fabricated parts.

### Summary

Disclosed herein is an apparatus for making a stereolithographic object. The apparatus comprises a material receiving surface for receiving a photohardenable material. The apparatus comprises
an actinic light emitter having an actinic emission spectrum and operable to generate an actinic light. The apparatus comprises an actinic light spectrum modifier having a spectral response profile and arranged to spectrally modify the actinic light. The actinic emission spectrum and the spectral response profile cooperate to shorten an absorption depth of the actinic light in the photohardenable material.

In an embodiment, the actinic light spectrum modifier is operable such that a longer wavelength component of the actinic light is attenuated more than a shorter wavelength component of the actinic light.

In an embodiment, the actinic light spectrum modifier is operable such that the optical power of the spectrally modified actinic light is less than 5% of the optical power of the actinic light at wavelengths greater than at least one of 380 nm, 385 nm, 390 nm, 395 nm, 400 nm, 405 nm, 410 nm, 415 nm, 420 nm, 425 nm, 430 nm, 435 nm, 440 nm, 445 nm, and 450 nm.

In an embodiment, the actinic light spectrum modifier comprises an optical filter.

An embodiment comprises an actinic light collimator cooperatively arranged with the actinic light source to generate collimated actinic light.

An embodiment comprises an optical mask generator optically downstream of the actinic light spectrum modifier.

In an embodiment, the actinic light spectrum modifier can be operationally decoupled from the actinic light source. The actinic light spectrum modifier may be movably mounted for operational decoupling from the actinic light source. The actinic light spectrum modifier may be motorised for operational decoupling from the actinic light source.

In an embodiment, the actinic light emitter comprises a light emitting diode (LED) operable to emit UVA light and visible violet light.

An embodiment comprises the photohardenable liquid received by the material receiving surface, wherein the photohardenable liquid comprises a photoinitiator responsive to visible violet light. The photohardenable liquid may comprise a dye dissolved therein. The photohardenable liquid may be clear and colourless. The dye absorption spectrum may overlap the absorption spectrum of the photoinitiator. The dye absorption spectrum may overlap the entire portion of the light spectrum modifier transmission spectrum which is absorbable by the photoinitiator absorption spectrum. The photoinitiator may comprise a substituted acyl phosphine oxide photoinitiator. The photoinitiator may comprise one of 2,4,6-trimethylbenzoyldiphenyl phosphine oxide, phenylbis(2,4,6-trimethylbenzoyl)phosphine oxide, ethyl-2,4,6-trimethylbenzoylphenylphosphinate, ethyl (3-benzoyl-2,4,6-trimethylbenzoyl)(phenyl)phosphinate, and (2,4, 6-trimethylbenzoyl) bis (p-Tolyl) phosphine oxide.

Disclosed herein is material hardenable by absorption of actinic light. The material comprises a liquid. The liquid comprises at least one of polymerizable monomers and oligomers. The liquid comprises a photoinitiator. The liquid comprises a dye that is clear and colourless, and having an absorption spectrum that overlaps the absorption spectrum of the photoinitiator
wherein the liquid is clear and colourless.

Disclosed herein is a stereolithographic object having a cure depth of less than 0.5 mm.

In an embodiment, the stereolithographic material comprises a clear and colourless cured material.

Disclosed herein is a method for making a stereolithographic object. The method comprises disposing a material hardenable by absorption of an actinic light having an actinic emission spectrum on a material receiving surface. The method comprises spectrally modifying the actinic light with an actinic light spectrum modifier having a spectral response profile, wherein the actinic emission spectrum and the spectral response profile cooperate to shorten an absorption depth of the actinic light. The method comprises illuminating the material receiving surface with the actinic light so modified.

An embodiment comprises iterating the steps of:
illuminating the material receiving surface with the actinic light so modified, and
increasing a separation between the material receiving surface and a build platform on which the stereolithographic object is made.

An embodiment comprises at least one of operationally decoupling the actinic light spectrum modifier from the actinic light source and operationally coupling the actinic light spectrum modifier from the actinic light source.

Disclosed herein is a method in accordance with the above disclosure executed by an apparatus in accordance with the above disclosure.

Disclosed herein is a method in accordance with the above disclosure wherein the material is in accordance with the above disclosure.

Any of the various features of each of the above disclosures, and of the various features of the embodiments described below, can be combined as suitable and desired.

### Brief description of the figures

Embodiments will now be described by way of example only with reference to the accompanying figures in which:
Figure 1 shows an actinic light absorption spectrum for the photoinitiator TPO that may be used in stereolithography.
Figure 2 shows a schematic diagram of an embodiment of an apparatus for making an object.
Figure 3 shows a plurality of example emission spectra of a plurality of example aLEDs.
Figure 4 show an example spectral response of an actinic light spectrum modifier.
Figure 5 shows spectra of an actinic light absorbable by TPO before and after it is modified by the actinic light spectrum modifier.
Figure 6 shows a schematic diagram of another embodiment of an apparatus for making an object.
Figure 7 shows a schematic diagram of an example of a vessel that can be used with the apparatuses of figures 2 and 6.
Figure 8 shows a light absorption spectrum for the material Tinuvin P.
Figure 9 shows a flow diagram for an embodiment of a method for making a stereolithographic object.
Figure 10 shows a schematic diagram of a processor for the apparatuses of figures 2 and 6.
Figure 11 to 14 show photographs of fabricated stereolithographic objects and their nominal geometry.

### Description of embodiments

Figure 2 shows a schematic diagram of an embodiment of an apparatus for making a stereolithographic object, the apparatus being generally indicated by the numeral 10 and is in the form of a stereolithographic 3D printer. The apparatus 10 comprises a material receiving surface 12 for receiving a material 14 that is hardenable by absorption of actinic light 16. The material receiving surface 12 is a surface of a window 22 comprising a material transparent to the actinic light 16.

The material 14 may generally be any suitable and desired material, however in this example the material 14 is a photohardenable liquid ("resin") comprising a dissolved photoinitiator in the form of TPO that is sensitive to violet light. Examples of photohardenable materials include but are not limited to photohardenable liquids *Somas NEXT* from DSM Somos, USA, KZ-1860-CL from Allied PhotoPolymers, USA and photohardenable liquids commercially supplied by ASIGA, Australia. Alternative examples of materials may optionally comprise fillers, examples of which include but are not limited to glass or ceramic powder and may be in the form of a paste; and pigments for colouring the material. Other examples of photohardenable liquids that may be suitable and desirable may comprise alternative and/or additional photoinitiators, examples of which include phenylbis(2,4,6-trimethylbenzoyl)phosphine oxide ("BAPO" available from BASF), ethyl-2,4,6-trimethylbenzoylphenylphosphinate ("TPO-L" available from BASF), ethyl (3-benzoyl-2,4,6-trimethylbenzoyl)(phenyl)phosphinate ("Speedcure XKm" available from Arkema, UK), and (2,4, 6-trimethylbenzoyl) bis (p-Tolyl) phosphine oxide ("TMO" available from LIFTCHEM, China).

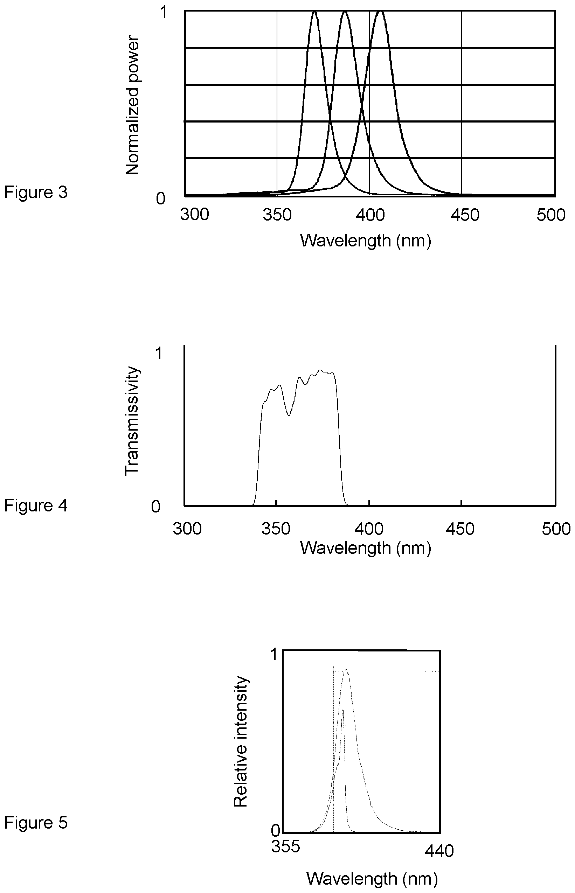

The apparatus 10 comprises an actinic light emitter 18 in the form of an actinic light emitting diode (aLED) operable to generate the actinic light 16. The actinic light emitter 18 has an actinic emission spectrum having an emission peak at 385 nm and a spectral width of around 50 nm. Figure 3 shows three emission spectra from three different commercially available aLEDs, which may be used when suitable and desired. The figure 3 emission spectra indicate visible violet light emission and/or long wave ultraviolet light emission (UVA). In the context of this document, the boundary between visible violet light and UVA light is at a wavelength of 400 nm.

The apparatus 10 comprises an actinic light spectrum modifier 20 in the form of a thin film optical band-pass filter. The spectral response of the actinic light spectrum modifier 20 is a pass band centred on 365 nm with a full width half maximum (FWHM) of 40 nm, as shown in Figure 4. The wavelength spectrum modifier 20 passes no more than around 50% of the incident light at 385nm and no more than around 1% of the incident light at wavelengths greater than about 390 nm. In an alternative embodiment, the actinic light spectrum modifier 20 is an optical low-pass filter with a pass band of less than 390nm. In the present but not necessarily in all embodiments, the actinic light spectrum modifier is operable such that the optical power of the spectrally modified actinic light is less than 5% of the optical power of the actinic light at wavelengths greater than at least one of 380 nm, 385 nm, 390 nm, 395 nm, 400 nm, 405 nm, 410 nm, 415 nm, 420 nm, 425 nm, 430 nm, 435 nm, 440 nm, 445 nm, and 450 nm.

The actinic emission spectrum of the aLED 18 and the spectral response of the actinic light spectrum modifier 20 cooperate to shorten an absorption or penetration depth of the actinic light within the material 14. The actinic emission spectrum and the spectral response profile overlap to remove a majority of the violet light from the actinic light 16. Figure 5 shows a spectrum of the actinic light before it is modified by the actinic light spectrum modifier 20 (the broader spectrum) and another spectrum of the actinic light after it has been modified by the actinic light spectrum modifier 20 (the narrower spectrum). The removed longer wavelengths of visible violet light is absorbed less than the remaining UV-A light. Consequently, the absorption or penetration depth of the actinic light 16 after passing through the optical filter 20 is shorter than the absorption depth of the actinic light 16 emitted by the actinic light emitter 18.

Optionally, the apparatus 10 can be configured such that the actinic light spectrum modifier 20 can be moved in and out of the optical path of the actinic light, as indicated by arrow 26, by the action of an actuator 27. The actinic light spectrum modifier 20 in some embodiments is movably mounted, for example mounted to a manually operated and/or motorised filter wheel (for example Thorlabs FW2126 with integrated controller and USB interface), or filter arm. The actinic light spectrum modifier 20 can be alternatively or additionally removably mounted in a filter holder. This actinic light spectrum modifier 20 may be moved out of the optical path of the actinic light 16 when, for example, using a photoinitiator less sensitive to longer visible violet wavelengths, or when fabrication speed is a priority. In an alternative embodiment, a plurality of turning mirrors is arranged to make the actinic light bypass the actinic light spectrum modifier. In some of these embodiments, the actinic light spectrum modifier can generally be operationally decoupled from the actinic light source and subsequently operationally coupled to the actinic light source, as required.

The position of actuator 27 is controlled by processor 50 according to the settings of an input program.

The apparatus 10 optionally comprises a light pattern generator 28 in the form of a digital light engine optically intermediate the actinic light spectrum modifier 20 and the material receiving surface 12. The digital light engine 28 is operable as a mask to pattern the actinic light 16 and so the configuration of a hardened layer of the material 14. The light engine 28 comprises a digital micromirror device, and receives control signals via a HDMI or other communications interface from processor 50. Light engines may be purchased from YOUNG OPTICS, Taiwain. Alternatively, the actinic light generator 28 may be configured to scan the actinic light, for example.

The apparatus 10 comprises a build platform 100 comprising a build surface 102 for fabricating stereolithographic objects thereon. The build platform 100 is coupled to a motorised positioner 104 operable to move the build surface 102 towards and away from the material receiving surface 12. A first layer of the stereolithographic object 106 is formed on the build surface 102 by moving the build surface 102 into the material 14 and illuminating the material receiving surface 12 through the window 22 and so the material 14 received thereon, causing a layer of the material 14 to harden in accordance with the actinic light patterned by the light pattern generator 28. Upon exposure with actinic light, material 14 hardens to a "cure depth" dependent on the penetration depth of the actinic light into the material 14 and the exposure dose which is a product of the exposure intensity (typically measured in milliwatts-per-square-centimetre) and the exposure time in seconds. Before each of the subsequent layers are formed, the motorised positioner 104 is operated to increase the separation between the build surface 102 and the material receiving surface 12. The increment in the separation is the nominal thickness of the layer to be formed, i.e. the "nominal layer thickness" or "slice thickness". The nominal layer thickness of one layer is generally in the range of 10 micrometers to 250 micrometers, but it may be less if particularly fine fabrication resolution is required, and greater if a relatively coarse fabrication resolution is required. The cure depth must equal or exceed the nominal layer thickness in order for the cured layer to adhere to previously formed layer. Ideally the cure depth is as close to the layer thickness as possible, as the greater the amount the cure depth exceeds the layer thickness, the worse the fidelity of the fabricated part. Being able to control the cure depth may generally be beneficial in being able to improve the fidelity of the fabricated part.

The motorized positioner 104 may comprise linear drive belts, stepper motors, rack and pinion arrangements, for example, or generally any suitable components arranged to actuate the movement. The motorised positioner 104 is optionally able to acquire a position within 0.01 - 100 µm. That is, the motorised positioner has "micron precision".

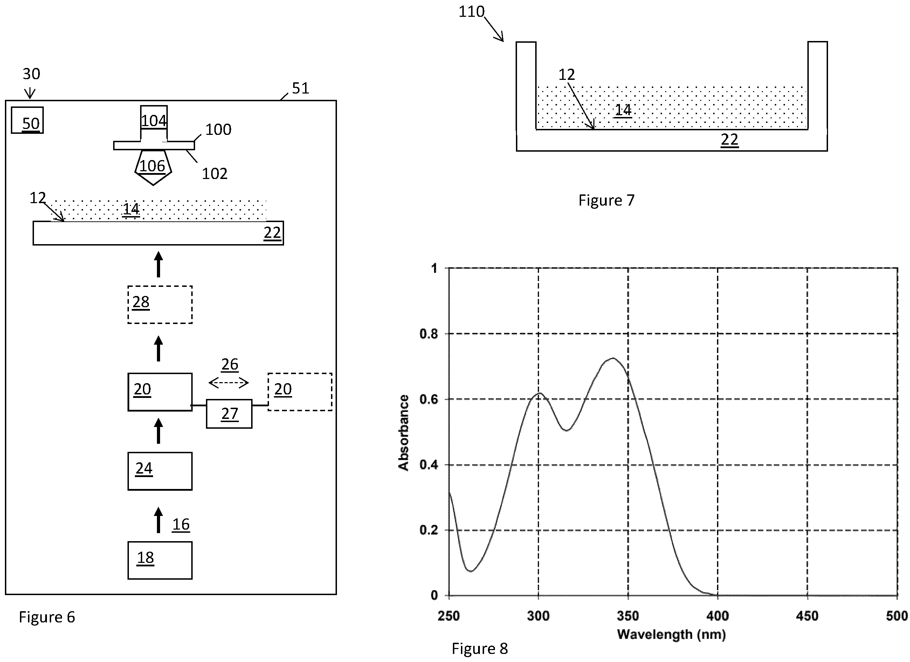

Figure 6 shows a schematic diagram of another embodiment of an apparatus 30 for making an object, where parts similar or identical in form and/or function to parts in figure 2 are similarly numbered. Apparatus 30 comprises collimation optics 24 ("collimator") in the form of a lens optically intermediate the actinic light emitter 18 and the actinic light spectrum modifier 20. The collimator 24 receives the actinic light 16 and collimates it for the actinic light spectrum modifier 20 to receive collimated actinic light 16. This may improve the performance of the actinic light spectrum modifier, as performance may be dependent on the incident angle of the actinic light on the actinic light spectrum modifier.

In the context of this document, the meaning of *optically intermediate,* encompasses an optical component that is inserted into an optical path connecting two other optical components.

Figure 7 shows a vessel 110 for containing the material 14 that the apparatus 10, 30 can optionally comprise. The vessel 110 comprises window 22 comprising the material receiving surface 12. The vessel 110 may contain the material 14, especially when an appreciable quantity of photohardenable liquid is disposed on the material receiving surface 12. It may not be necessary to use the vessel 110, however. The material 14 may be, for example, sprayed or wiped onto the material receiving surface 12.

When fabricating an object using apparatus 10, 30, the photohardenable liquid 14 received by the material receiving surface 12 optionally comprises a dye. The photohardenable liquid 14 comprising the dye is generally selected to be clear and colourless, and further shortens the absorption or penetration depth of the actinic light within the material 14. Consequently, the fabricated object may be comprised of solidified material that is clear, colourless, and relatively better resolution.

In the context of the present document:
- a material, for example a photohardenable liquid, is clear and colourless if the colour and clarity of a 6,500K temperature light bulb is imperceptibly changed when viewed through a 10 mm diameter test tube containing the material.
- a solidified material is colourless and clear provided that the colour and clarity of a 6,500K temperature (daylight) light bulb is imperceptibly changed when viewing through a 10 mm thick plate of the material.

Photohardenable liquid and a solidified material can be tested for clarity and colour using a 6,500K light bulb and a 10 mm test tube in accordance with the above definitions, which are generally suitable for many applications. Similar but different tests, however, may be defined using different light sources having different colour temperatures, and vessels other than a 10 mm test tube as suitable and desired.

The dye absorption spectrum, photoinitiator absorption spectrum, actinic light spectrum modifier transmission spectrum, actinic emission spectrum, and visible light spectrum, are each characterised by optical spectra having a value of intensity (representing transmission or absorption) as a function of light wavelength. The dye transmission spectrum and photoinitiator absorption spectrum are concentration and path-length dependent, so their transmission (or absorption) spectrum values are functions of wavelength, their concentration in the photohardenable liquid, and the propagation distance in the photohardenable liquid. These spectra may be beneficially selected in specific relation to each other. These spectra are related generally, but not necessarily, by the following relationships:
- The light spectrum modifier transmission spectrum overlaps a portion of the actinic emission spectrum.
- The dye absorption spectrum overlaps the entire portion of the light spectrum modifier transmission spectrum.
- The dye absorption spectrum overlaps the entire portion of the light spectrum modifier transmission spectrum which is absorbable by the photoinitiator absorption spectrum.
- The dye absorption spectrum overlaps a portion of the photoinitiator absorption spectrum.
- The light spectrum modifier transmission spectrum overlaps a portion of the photoinitiator absorption spectrum.

Additionally, where the objective is to fabricate a clear and colourless part:
- The dye absorption spectrum does not appreciably overlap the visible violet light band.
- The light spectrum modifier transmission spectrum does not appreciably overlap the visible light spectrum.

To realise a resin which can be used to fabricate clear and colourless part that also realises high geometric fidelity, the dye may be selected from dyes which absorb in the ultraviolet wavelengths at which the photoinitiator is active, and where the dye is also largely inactive in the visible wavelengths. Furthermore, the light spectrum modifier preferably passes only light which is attenuated by the dye and also activates the photoinitiator. The light spectrum modifier may additionally pass light which does not activate the photoinitiator without detrimental effect.

An example of a photohardenable liquid here identified as "Example 1" comprising a dye that may be suitable comprises 80 parts of urethane dimethacrylate, 20 parts triethylene glycol dimethacrylate, 0.1 parts hydroxyphenyl-benzotriazole UV absorbing dye Tinuvin P which has an absorption band of below 250 nm to around 400 nm, and 0.2 parts photoinitiator 2,4,6-trimethylbenzoyldiphenyl phosphine oxide (TPO) which has an absorption range of below 250 nm to around 425 nm. Figure 8 shows an absorption spectra for Tunuvin P. In an example, the resulting photohardenable liquid is photohardend with light from an aLED with a centre wavelength of 385 nm and an emission spectrum spanning approximately 365 nm to 425 nm. Light from the aLED is passed through an optical filter with a pass band of 340 nm to 390 nm. This combination may enable the fabrication of relatively high resolution photohardened objects that are clear and colourless despite using a low-cost aLED light source having visibly violet emissions and a photoinitiator exhibiting some absorption in the visible spectrum.

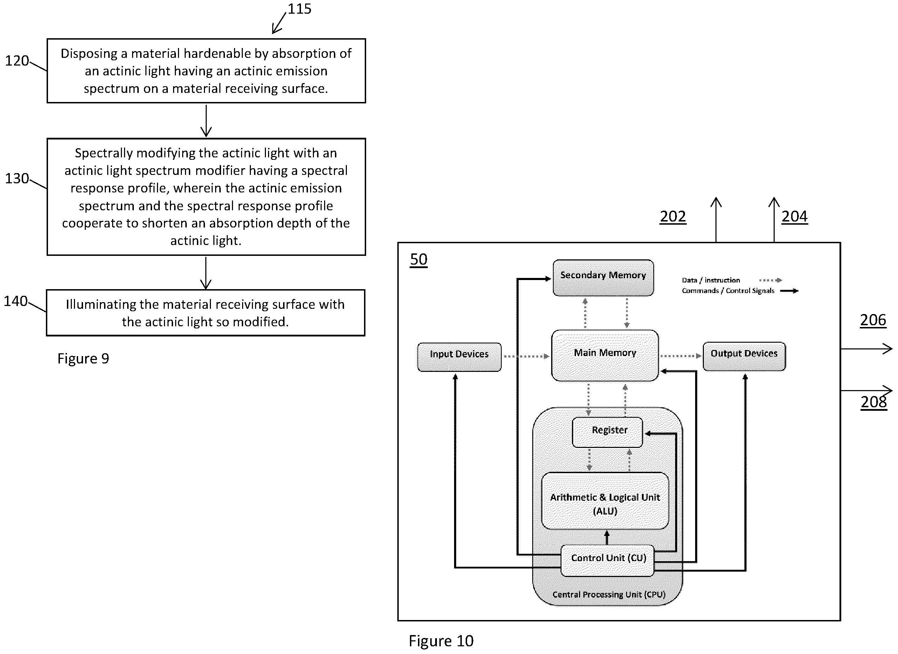

Steps of an embodiment of method 115 for making a stereolithographic object are now be described with reference to the flow chart in figure 9. Optionally, a photohardenable liquid in accordance with the above disclosure can be used. A step 120 comprises disposing the material 14 hardenable by absorption of the actinic light 16 having an actinic emission spectrum on the material receiving surface 12. A step 130 comprises spectrally modifying the actinic light 16 with the actinic light spectrum modifier 20 having a spectral response profile, wherein the actinic emission spectrum and the spectral response profile cooperate to shorten an absorption depth of the actinic light 16. A step 140 of the method comprises illuminating the material receiving surface 102 with the actinic light 16 so modified.

By shortening the absorption depth of the actinic light, the cure depth of the resin may be reduced, thereby improving the fidelity of the fabricated part. The cure depth of the layer may, for example, be 20 microns when fabricating delicate objects having nominal layer thicknesses of 10 microns. Alternatively, the cure depth may, for example, be 150 microns when fabricating objects having a nominal layer dye absorption thickness of 100 microns. Reducing the penetration depth of the actinic light into the resin also reduces the exposure of resin to low-irradiance actinic light which may not meet the threshold of hardening the resin, but can still cause partial curing of the resin to form a gel, which degrades the resin and can adhere to the fabricated part to detrimentally affect its geometric fidelity.

Optionally, a plurality of layers can be formed by repeating step 140, additionally with an increase in the separation of the build surface 102 and the material receiving surface 12 after the formation of each layer.

The apparatuses 10 and 30 optionally comprise a processor 50, a schematic diagram of which is shown in figure 10 (the processor may alternatively be supplied separately and connected via cable). The processor 50 is optionally housed in the apparatus's optional enclosure 51. In the precent embodiment, the processor 50 is in the form of a single board computer, a suitable example of which is the LattePanda Mu. The processor 50 comprises:
- non-transitory processor readable tangible media (secondary memory) in the form of a non-volatile 240 gigabytes (Gb) solid-state drive, or generally any suitable and desired media an example of which includes but is not limited to a flash memory card.
- volatile memory (main memory) in the form of 8 Gb of RAM
- A central processing unit in the form of an Intel N100 central processing unit
- communication interfaces suitable for communication with the processor externa; components, including for example the motorized positioner 104, the light source 18, the motorized actinic light spectrum modifier 20, optional light pattern generator 28, and optionally other components to coordinate the apparatus 10,30 to make the object 106. Communication may be via wires, cables, wireless, or any other suitable means using, for example, at least one of USB, GPIO, UART and I2C for example

The processor's non-transitory processor readable tangible media includes program instructions and /or a computer program that when executed by the processor 50 causes the processor 50 to perform the embodiment of a method for making a stereolithographic object shown in figure 9, for example, and may be adapted for other embodiments of the method for making the stereolithographic object as suitable and desired. The computer program may, for example, be written in the Python computer programming language and use suitable and desired packages, or written in any suitable programming language including LabVIEW and C. The program instruction may be in the form of executable binary files compiled from source code written in generally any suitable and desired computer programming language, an example of which is, but not limited to, C.

The processor 50 is in communication with another processor which is adapted for determining instructions and/or information for the processor 50. In alternative embodiments, the processors are the same processor. An example of another processor comprises a logic device such as, or similar to, the INTEL CORE ULTRA central processing unit or a suitably configured field programmable gate array (FPGA), connected over a bus to a random-access memory of around 8 Gb and a non-volatile memory of such as a hard disk drive or solid-state non-volatile memory having a capacity of around 250 GB. The processor has a communications interface such as a USB port (or Internet connection, for example) for receiving information representing a solid object, stored on a USB FLASH device, for example. The information may be encoded in a file generated by a Computer Aided Design (CAD) program, the information specifying the geometry of the object. The other processor runs a decomposer program implementing an algorithm that decomposes (or transforms) the information into data indicative of a plurality of layers to be formed sequentially by the 3D printer, the material being used to make the object. The program may have been installed onto the other processor from tangible media such as a DVD or USB memory stick, for example, that stored the program. In an alternative embodiment, the decomposer may be a dedicated hardware unit.

In this embodiment, the window 22 is not backed by another material or layer, and is homogeneous, that is has a uniform structure and composition throughout. In other embodiments the sheet may have a multilaminate construction. For example, the window 22 may comprise a layer of silicone bonded to a polyester film, the film providing a high Young's modulus and the silicone providing a superior nonstick surface in relation to the photohardenable material 14. Other materials or laminates of different materials may alternatively be used.

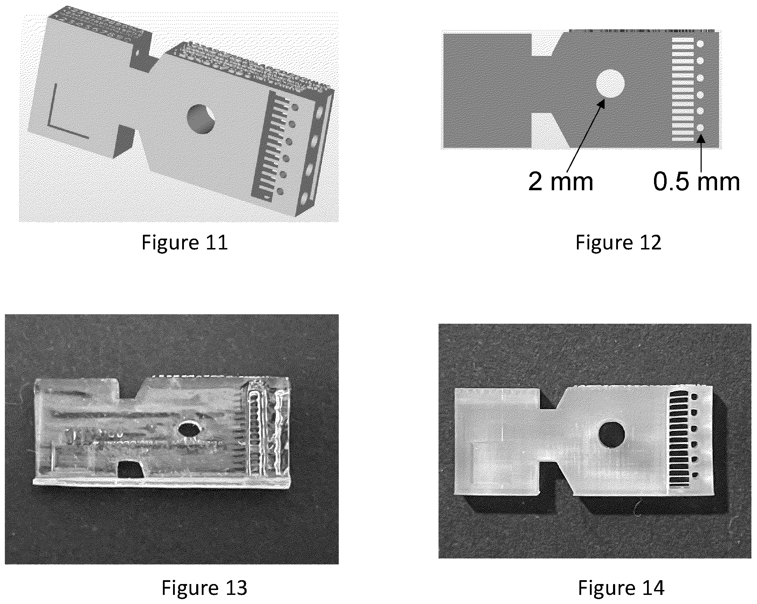

Figure 11 shows a computer-generated image of a 3D test object's geometry which has critical dimensions shown in Figure 12. Figure 13 shows the test object fabricated on an Asiga Max UV stereolithographic 3D printer (Asiga, Australia) using Keysplint Soft resin (Keystone, Inc., USA) using standard parameters provided by the material manufacturer. It can be seen that geometric fidelity is lost in some regions of the object due to high penetration depth of actinic light in the material. Figure 14 shows the same test object fabricated on an Asiga Max UV modified with a bandpass optical filter having centre wavelength of 365nm and full-width-half-maximum pass-band of 40nm according to the present invention, and using the "Example 1" photohardenable resin described herein. The fabricated object was optically clear and transparent and displayed improved geometric fidelity.

The object 106 may generally be any suitable object, examples of which include but are not limited to:
- medical prosthetics and implants
- dental prosthetics and implants
- hearing aid casings and earpieces
- prototypes and models
- jewellery
- artefact replicas
- miniatures
- goggles
- mouth guards
- mould master patterns, and
- industrial components.

Now that embodiments have been described, it will be appreciated that some embodiments may have some of the following advantages:
- The minimum thickness of a layer of the stereolithographic object may be lessened, which may result in improved layer resolution.
- The clarity and/or colour of the stereolithographic object may be improved.
- Attenuating the actinic light may reduce the light induced degradation of the optical mask generator.

Variations and/or modifications may be made to the embodiments described without departing from the spirit or ambit of the invention. For example:
- The material may generally be any suitable material as desired, including but not limited to resins and polymer precursors.
- The actinic light spectrum modifier may generally have any suitable alternative spectral response as suitable and desired, for example a passband centred on 365 nm and a FWHM of 40 mm, or a low pass filter having an edge at 390 nm. The actinic light spectrum modifier may pass light within a wavelength band centred between 345 nm and 400 nm.
- Generally, any optical filter that is suitable may be used additionally or alternatively to the thin film filter as desired, for example an absorptive filter. Alternatively or additionally, any suitable and desired wavelength selective device may be used, for example a diffraction grating.
- The light patterning system may generally additionally or alternatively comprise other components and/or systems, for example an optical scanning system.
- The window may generally comprise any suitable and desired material, for example glass.
- Any suitable photoinitiator may be used as desired, examples of which include but are not limited to benzoin ethers, benzyl ketals, α - dialkoxy-aceto-phenones, α-hydroxy-alkyl-phenones, α-amino alkyl-phenones, Acyl phosphine oxides, benzo-phenones/amines, thioxanthones/amines, and titanocenes.
- Any suitable UV absorbing dye - which may comprise a plurality of UV absorbing dyes - may be used as desired. Examples of UV absorbing dyes that may be suitable and desirable include but are not limited to:
   ∘ Benzotriazoles and derivatives thereof, including
      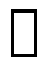 EVERSORB 78, EVERSORB 79 and EVERSORB 80 by Everlight Chemical Industrial Corporation (Taiwan)
      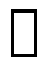 LOWILITE. 29 and LOWILITE 36 formally by Great Lakes Chemical Corporation (USA)
      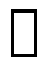 CHISORB 234, CHISORB 320, CHISORB 325, CHISORB 326 and CHISORB 327 formally by Cytec Technology Co. Ltd (USA)
      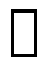 CYASORB UV-5365 formally by Cytec Technology Co. Ltd
      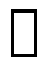 TINUVIN 326, TINUVIN 328, TINUVIN P by BASF
   ∘ Triazine-based and derivatives thereof, including
      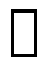 CHISORB 328 and CYASORB UV-1164 formally by Cytec Technology Co., Ltd. (USA)
   ∘ Benzophenones and derivatives thereof, including
      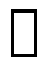 UVINUL 3000, UVINUL 3008, UVINUL 3040, UVINUL 3048, UVINUL 3049 and UVINUL 3050 by BASF
      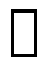 CYASORB UV-531 formally by Cytec Technology Co. Ltd. (USA)
   o Diphenyl acrylates and derivatives thereof, including
      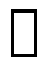 UVINUL 3030, UVINUL 3035, UVINUL 3039, and UVINUL 3088 by BASF
   ∘ Hindered benzoate and derivatives thereof, including
      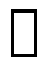 CYASORB UV-2908 formally by Cytec Technology Co. Ltd. (USA)
   o Benzoxazine and derivatives thereof, including
      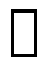 CYASORB UV-3638 formally by Cytec Technology Co. Ltd. (SA)
   o Hydroxybenzophenones and derivatives thereof
   o Benzoxazinones and derivatives thereof
- Any suitable optical component or components that suitably attenuates the unwanted light wavelengths may be used as desired, examples of which may generally include an optical prism and diffracting optics.

The present embodiments are, therefore, to be considered in all respects as illustrative and not restrictive.

Reference to a feature disclosed herein does not mean that all embodiments must include the feature.

Prior art, if any, described herein is not to be taken as an admission that the prior art forms part of the common general knowledge in any jurisdiction.

In the claims which follow and in the preceding description of the invention, except where the context requires otherwise due to express language or necessary implication, the word "comprise" or variations such as "comprise"" or "comprising"" is used in an inclusive sense, that is to specify the presence of the stated features but not to preclude the presence or addition of further features in various embodiments of the invention.

## Claims

1. An apparatus for making a stereolithographic object, the apparatus comprising:
a material receiving surface for receiving a photohardenable material;
an actinic light emitter having an actinic emission spectrum and operable to generate an actinic light; and
an actinic light spectrum modifier having a spectral response profile and arranged to spectrally modify the actinic light, wherein the actinic emission spectrum and the spectral response profile cooperate to shorten an absorption depth of the actinic light in the photohardenable material.

2. An apparatus defined by claim 1 wherein the actinic light spectrum modifier is operable such that a longer wavelength component of the actinic light is attenuated more than a shorter wavelength component of the actinic light.

3. An apparatus defined by either one of claim 1 and claim 2 wherein the actinic light spectrum modifier is operable such that the optical power of the spectrally modified actinic light is less than 5% of the optical power of the actinic light at wavelengths greater than at least one of 380 nm, 385 nm, 390 nm, 395 nm, 400 nm, 405 nm, 410 nm, 415 nm, 420 nm, 425 nm, 430 nm, 435 nm, 440 nm, 445 nm, and 450 nm.

4. An apparatus defined by any one of preceding claims wherein the actinic light spectrum modifier comprises an optical filter.

5. An apparatus defined by any one of the preceding claims comprising an actinic light collimator cooperatively arranged with the actinic light source to generate collimated actinic light.

6. An apparatus defined by any one of the preceding claims comprising an optical mask generator optically downstream of the actinic light spectrum modifier.

7. An apparatus defined by any one of the preceding claims wherein the actinic light spectrum modifier can be operationally decoupled from the actinic light source.

8. An apparatus defined by claim 7 wherein the actinic light spectrum modifier is movably mounted for operational decoupling from the actinic light source.

9. An apparatus defined by claim 8 wherein the actinic light spectrum modifier is motorised for operational decoupling from the actinic light source.

10. An apparatus defined by any one of the preceding claims wherein the actinic light emitter comprises a light emitting diode (LED) operable to emit UVA light and visible violet light.

11. An apparatus defined by any one of the preceding claims comprising the photohardenable liquid received by the material receiving surface, wherein the photohardenable liquid comprises a photoinitiator responsive to visible violet light.

12. An apparatus defined by claim 11 wherein the photohardenable liquid comprises a dye dissolved therein.

13. An apparatus defined by claim 12 wherein the photohardenable liquid is clear and colourless.

14. An apparatus defined by any one of the claims 11 to 13 wherein the dye absorption spectrum overlaps the absorption spectrum of the photoinitiator.

15. An apparatus defined by any one of the claims 11 to 13 wherein the dye absorption spectrum overlaps the entire portion of the light spectrum modifier transmission spectrum which is absorbable by the photoinitiator absorption spectrum.

16. An apparatus defined by any one of the claims 11 to 15 wherein the photoinitiator comprises a substituted acyl phosphine oxide photoinitiator.

17. An apparatus defined by any one of the claims 11 to 16 wherein the photoinitiator comprises one of 2,4,6-trimethylbenzoyldiphenyl phosphine oxide, phenylbis(2,4,6-trimethylbenzoyl)phosphine oxide, ethyl-2,4,6-trimethylbenzoylphenylphosphinate, ethyl (3-benzoyl-2,4,6-trimethylbenzoyl)(phenyl)phosphinate, and (2,4, 6-trimethylbenzoyl) bis (p-Tolyl) phosphine oxide.

18. A material hardenable by absorption of actinic light, the material comprising:
a liquid comprising:
at least one of polymerizable monomers and oligomers;
a photoinitiator; and
a dye that is clear and colourless, and having an absorption spectrum that overlaps the absorption spectrum of the photoinitiator
wherein the liquid is clear and colourless.

19. A stereolithographic object having a cure depth of less than 0.5 mm.

20. A stereolithographic object defined comprising claim 19 comprising a clear and colourless cured material.

21. A method for making a stereolithographic object, the method comprising:
disposing a material hardenable by absorption of an actinic light having an actinic emission spectrum on a material receiving surface;
spectrally modifying the actinic light with an actinic light spectrum modifier having a spectral response profile, wherein the actinic emission spectrum and the spectral response profile cooperate to shorten an absorption depth of the actinic light; and
illuminating the material receiving surface with the actinic light so modified.

22. A method defined by claim 21 comprising, iterating the steps of:
illuminating the material receiving surface with the actinic light so modified, and
increasing a separation between the material receiving surface and a build platform on which the stereolithographic object is made.

23. A method defined by either one of claim 21 and claim 22 comprising at least one of operationally decoupling the actinic light spectrum modifier from the actinic light source and operationally coupling the actinic light spectrum modifier from the actinic light source.

24. A method defined by either on one of the claims 22 and 23 executed by the apparatus defined by any one of the claims 1 to 17.

25. A method defined by any one of the claims 23 to 23 wherein the material is defined by any one of the claims 18 to 20.
